# EUROPEAN PATENT SPECIFICATION

(11) **EP 1 833 048 B1**
(45) Date of publication and mention of the grant of the patent: **28.04.2010**
(21) Application number: 07103426.8
(22) Date of filing: 02.03.2007
(51) Int. Cl.: G11B 7/0065

(54) **Hologram recorder and hologram recording method**
Hologrammaufzeichnungsgerät und Hologrammaufzeichnungsverfahren
Enregistreur d'hologramme et procédé d'enregistrement d'hologramme

(30) Priority: 06.03.2006 JP 2006059118
(43) Date of publication of application: 12.09.2007
(73) Proprietor: Fujitsu Ltd., Kawasaki-shi, Kanagawa 211-8588 (JP)
(72) Inventor: Uno, Kazushi Fujitsu Limited, Kanagawa 211-8588 (JP); Yamakage, Yuzuru Fujitsu Limited, Kanagawa 211-8588 (JP)
(74) Representative: Seeger, Wolfgang

(56) References cited:
- EP-A2- 0 817 201
- WO-A-2004/112045
- US-A1- 2006 007 512
- US-A1- 2007 008 598

## Description

### BACKGROUND OF THE INVENTION

### 1. Field of the Invention:

The present invention relates to hologram recorders for multiple hologram recording by an multiple angle method, for example.

### 2. Description of the Related Art:

A conventional hologram recorder is disclosed in e.g. JP-A-H04-93881. This hologram recorder uses the so-called multiple angle method. In the multiple angle method, a recording beam which is modulated in accordance with information to be recorded and a reference beam of the same wavelength are applied to a unit recording region of the hologram recording medium, and variable control is made so that the reference beam has a plurality of incident angles. The recording beam is directed to the unit recording region so that it will make interference each time the reference beam takes a predetermined angle, whereby multiple recording of holograms is achieved with each page containing a hologram which is specific to the incident angle of the reference beam.

For data reproduction, variable control is performed so that the reference beam incident angle becomes the same as the one used for the recording. In the reproduction, only the reference beam is applied to the unit recording region. If the reference beam incident angle is not exactly the same as during the recording, diffraction efficiency will be very low and it becomes impossible to obtain a reproduction beam of a desired luminance from the unit recording region. Therefore, according to the conventional hologram recorder disclosed in JP-A-H04-93881, an index region is provided in the vicinity of the unit recording region, and incident angle information is written in the index region when a hologram is recorded. For reproduction, the incident angle information is read out, and the reference beam incident angle is aligned on the basis of the incident angle information.

However, in the above-described conventional hologram recorder, it is known that shrinkage of the medium or wavelength variation is likely to occur when applying laser beams such as the recording beam and the reference beam. These will alter beam application conditions at the time of reproduction from the conditions at the time of recording. Therefore, even if the alignment of the reference beam incident angle is accomplished accurately based on the incident angle information contained in the record, the incident angle is still likely to be out of alignment. Such a risk can be avoided if fine control is provided to the reference beam incident angle when receiving the reproduction beam, but this will pose a strict limitation on reproduction speed.

There is another problem. If multiplicity is increased by increasing the number of hologram pages recordable in the unit recording region, a more stringent condition must be cleared in terms of angle selectivity to achieve sufficient diffraction efficiency for reproduction of the holograms page by page. This means that, alignment of the reference beam incident angle must be achieved within a very narrow tolerance range in order to obtain a reproduction beam of a sufficient luminance. In other words, reproduction condition will become more stringent with increasing recording density, which will also make it difficult to increase reproduction speed. This problem of reproduction speed has been common and there has been room for improvement not only in the multiple angle method but also in other methods such as in multiple wavelength method and in multiple speckle method.

US 2006/007512 A1 describes a hologram recording apparatus and hologram recording method. At the time of varying the angle of a scan mirror for varying the angle of incidence of a reference beam on a hologram recording material, the angle of a slit is also varied in conjunction, whereby the beam diameter of the reference beam is varied by the slit so that the irradiation range on the hologram recording material will be constant without being varied according to the variation in the incidence angle of the reference beam.

In one angle-multiplexing holography arrangement described in US 2006/007512 A1 the beam angle is continuously varied within a certain angular range during recording of each data page, thus the angular selectivity is lowered in order to allow for deviations due to temperature variation.

US 2007/008598 A1 and JP 2005 031395 A describe a holographic recorder and recording method for holographic data storage, where on each page there is recorded address information in address areas arranged at different positions.

### SUMMARY OF THE INVENTION

The present invention has been proposed under the above-described circumstances. It is therefore an object of the present invention to provide a hologram recorder capable of enjoying increased reproduction speed. The invention is defined by the appended claims.

With such arrangements as described above, take the multiple angle method, for example, in which the incident angle of reference beam is varied: When recording holograms at the reference beam incident angle in alignment with the reference angle, the incident angle is continuously varied within a predetermined angular range. Therefore, holograms which are made of substantially the same interference patterns are recorded densely in the page when recording is made at the reference angle. In reproducing the holograms from the page where recording was made at the reference angle, a sufficient reproduction beam is obtained even if there is a certain amount of error in the reference beam incident angle. Therefore, in reproducing holograms from a plurality of pages including a page recorded at the reference angle, it is possible to obtain reproduction beams of a sufficient luminance even if reproduction conditions are lowered to allow a rough alignment of the reference beam incident angle. This makes it possible to read the multiple holograms more quickly, page by page, while making reference to the page recorded at the reference angle. Specifically, the arrangements according to the present invention can provide such an advantage as increased reproduction speed through a lowered reproduction condition.

Such an advantage as described above is also achievable in e.g. multiple wavelength method in which the beam wavelength of the recording beam and of the reference beam is varied whereby multiple recording is made at a predetermined wavelength interval: In this case the beam wavelength is continuously varied within a predetermined wavelength range when aligning the beam wavelength with a specific reference wavelength. Same applies to multiple speckle method in which the speckle size of the reference beam is varied whereby multiple recording is made at a predetermined size range: In this case, the speckle size is continuously varied within a predetermined size range when aligning the speckle size with a specific reference size.

Other characteristics and advantages of the present invention will become clearer from the following detailed description to be made with reference to the attached drawings.

### BRIEF DESCRIPTION OF THE DRAWINGS

Fig. 1 shows the overall configuration of a hologram recorder according to a first embodiment of the present invention.
Fig. 2 is a schematic view illustrating the hologram recording operation of the recorder of Fig. 1.
Fig. 3 is a plan view illustrating the spatial modulation pattern shown in Fig. 2.
Fig. 4 is a schematic view illustrating the hologram reproducing operation of the recorder of Fig. 1.
Figs. 5A and 5B are graphs illustrating the optical properties of holograms.
Fig. 6 is a flow chart showing the recording procedure by the hologram recorder of Fig. 1.
Fig. 7 is a flow chart showing the reproducing procedure by the hologram recorder of Fig. 1.
Fig. 8 is a flow chart showing the procedure following that of Fig. 7.
Fig. 9 shows the overall configuration of a hologram recorder according to a second embodiment of the present invention.
Fig. 10 shows the overall configuration of a hologram recorder according to a third embodiment of the present invention.

### DETAILED DESCRIPTION OF THE PREFERRED EMBODIMENTS

Preferred embodiments of the present invention will be described below with reference to the drawings.

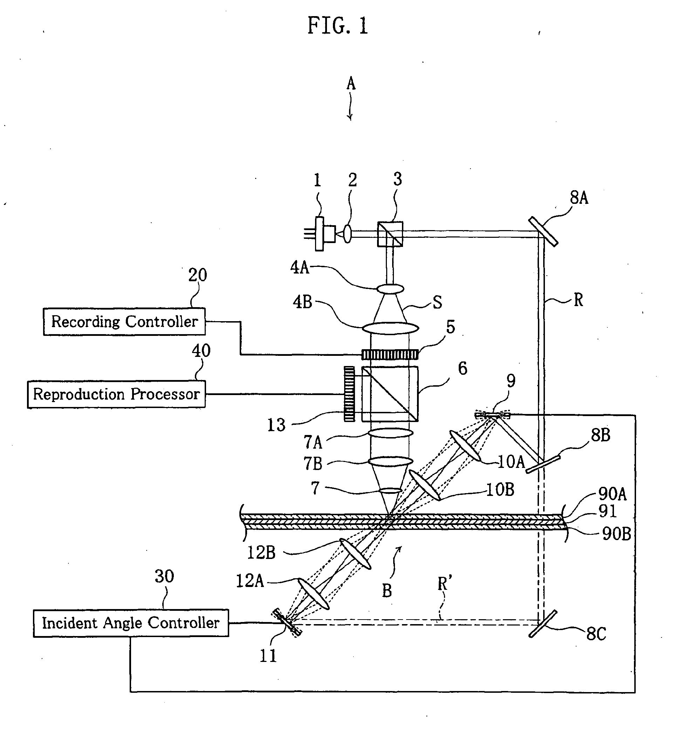

Referring to Fig. 1, the hologram recorder A according to the present embodiment is configured to operate in accordance with the so-called multiple angle method for performing multiple holographic recording, while also configured to be capable of reproducing holograms. The optical system of the recorder A includes a light source 1, a collimating lens 2, a first beam splitter 3, beam expanders 4A, 4B, a spatial light modulator 5, a second beam splitter 6, relay lenses 7A, 7B, an object lens 7, fixed mirrors 8A, 8B, 8C, a recording galvanometer mirror 9, recording condenser lenses 10A, 10B, a reproduction galvanometer mirror 11, reproduction condenser lenses 12A, 12B, and a photo detector 13. These elements are mounted on a pickup, which is not shown. The spatial light modulator 5 is controlled by a recording controller 20. The recording and the reproduction galvanometer mirrors 9, 11 are controlled by an incident angle controller 30. The photo detector 13 is connected with a reproduction processor 40. Other elements which are not illustrated include, for example, a rotation mechanism for rotating a disc-shaped hologram recording medium B, a tracking servo mechanism for moving the pickup unit in radially of the hologram recording medium B, and a microcomputer which provides overall control. The recording controller 20, the incident angle controller 30, and the reproduction processor 40 are connected with the microcomputer.

The hologram recording medium B which is used in the hologram recorder A has a recording layer 91 sandwiched between two optically transparent protective layers 90A, 90B. Beams can be applied to the recording layer 91 from both sides. As a recording beam S and a reference beam R interfere with each other while crossing at a predetermined angle, holograms each having an interference stripe pattern specific to the crossing angle are recorded in the recording layer 91. For reproduction, only the reference beam R is applied as indicated by phantom lines, to the hologram recording medium B from the opposite side as was during the recording. If the beam is applied to a recorded portion of the recording layer 91, the reference beam R interferes with the recorded hologram thereby generating a diffraction beam, and the diffraction beam which serves as a reproduction beam travels to the object lens 7.

The light source 1, which is provided by e.g. a semiconductor laser device, outputs a laser beam serving as coherent light at the time of recording and reproducing. The collimating lens 2 converts the laser beam from the light source 1 into a parallel beam. The parallel beam from the collimating lens 2 travels to the first beam splitter 3. The first beam splitter 3 splits the incoming parallel beam into a recording beam S which travels to the spatial light modulator 5, and a reference beam R which travels through a different optical path to the recording and the reproduction galvanometer mirrors 9, 11. Thus, the wavelength of the reference beam R at a time recording is always identical with the wavelength of the recording beam S. The beam expanders 4A, 4B, provided by combined lenses, expand the diameter of the recording beam S while introducing the recording beam S to the spatial light modulator 5.

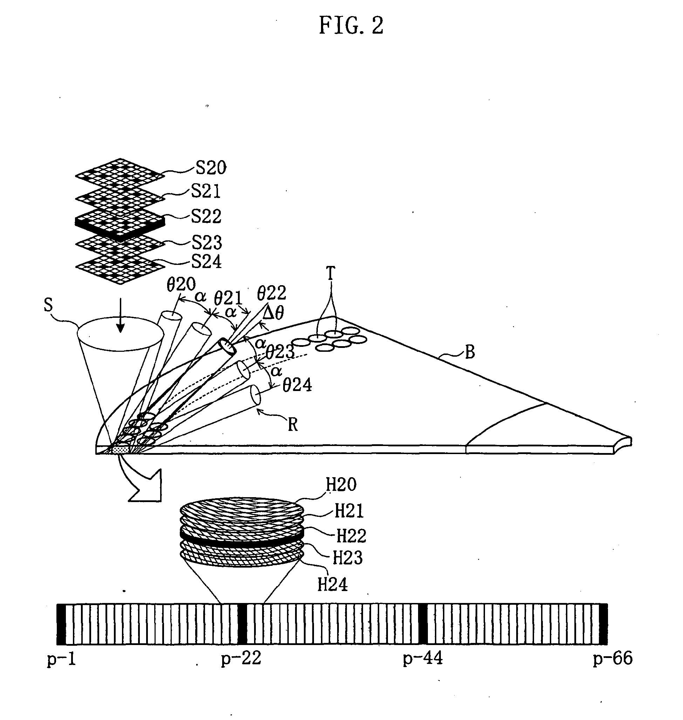

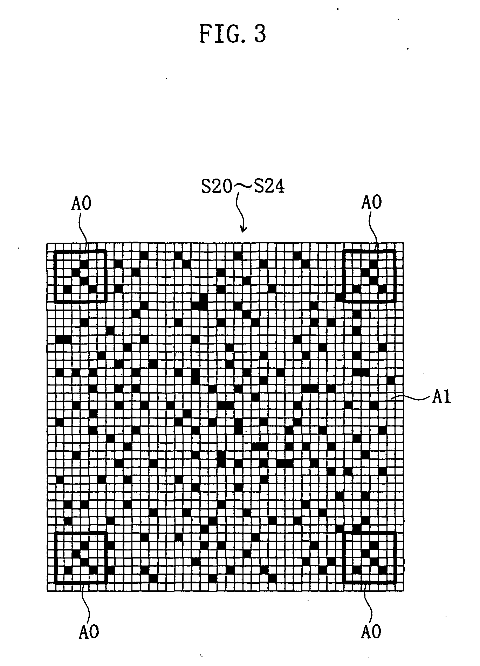

The spatial light modulator 5, provided by e.g. a liquid crystal display device, works at the time of recording, and modulates the incoming beam into a recording beam S which represents a two-dimensional spatial modulation pattern (pixel patterns indicated by reference codes S20 through S24 in Fig. 2). The recording controller 20 controls the spatial light modulator 5 so that different spatial modulation patterns S20 through S24 will be generated in accordance with information to be recorded. As exemplified in Fig. 3, the spatial modulation patterns S20 through S24 are two-dimensional pixel patterns created by conversion of data such as images and texts as an object of recording, as wall as e.g. address information. The address information is assigned to four ID areas A0 shown as bold-line boxes, while other information is assigned to another area than the ID area A0, i.e. a user area A1. These four ID areas A0 are signed with identical address information for the sake of redundancy, which serves to minimize error in reading address information. It should be noted here that the address information includes information indicating physical position (position address information) such as a position on the track in the hologram recording medium B, as well as information indicating a page (page address information) related to a specific beam incident angle of the reference beam R. For example, the page address information is expressed as a page number p-1 through p-66 as shown in Fig. 2. Though not illustrated, there is still another kind of information recorded by holography in the hologram recording medium B, including data management information which indicates what data is recorded on each page.

Returning again to Fig. 1, the recording beam S from the spatial light modulator 5 passes through the second beam splitter 6, the relay lenses 7A, 7B and the object lens 7, and then hits the hologram recording medium B. Meanwhile, the reference beam R from the first beam splitter 3 travels via the fixed mirrors 8A, 8B to the recording galvanometer mirror 9, reflects upon the galvanometer mirror 9, passes through the condenser lenses 10A, 10B, and then hits the hologram recording medium B to interfere with the recording beam S. As shown in Fig. 2, application of the recording beam S and the reference beam R is made for each unit recording region T, so as to make the beam cross each other at the unit recording region T. The unit recording region T as described is generally called book. In the present embodiment, the unit recording region T is formed sequentially along circumferential directions. It should be noted here that mutually adjacent unit recording regions T may overlap with each other within a range which will not cause crosstalk.

The recording beam S is applied substantially perpendicularly (at zero incident angle) to the unit recording region T. On the other hand, the reference beam R is applied from diagonally above, and the incident angle of the reference beam R is variably controlled in a predetermined angular interval α by a biasing movement of the galvanometer mirror 9. In this arrangement, a plurality of predetermined angles to which the reference beam R is aligned will be expressed as On (n represents an integer). In the present embodiment, the predetermined angular interval α is a constant interval. However, the angular interval α may be of inconsistent pitches.

Specifically, as exemplified in Fig. 2, the incident angle of the reference beam R is aligned to a plurality of predetermined angles θ20 through θ24 which are set at a predetermined angular interval α. Among these angles, the predetermined angle θ22 serves as a reference angle. In other words, the predetermined angles θn including the reference angle θ22 serve as target values in controlling the incident angle of reference beam R. Note, however, that the actual amount which is controlled is the deflection angle of the galvanometer mirror 9. In recording, when the incident angle of the reference beam R has become equal to the predetermined angle θ20 for example, the recording beam S and the reference beam R are applied to cross with each other. While the angle changes from the predetermined angle θ20 to the next predetermined angle θ21, the recording beam S and the reference beam R are not applied. When the incident angle of the reference beam R has changed from the predetermined angle θ20 to the next predetermined angle θ21, the spatial modulation pattern of the recording beam S is switched from S20 to S21. Thus, corresponding to the predetermined angles θ20, θ21, holograms H20, H21 each having a specific interference stripe pattern are recorded on respective pages p-20, p-21. These pages which correspond to the predetermined angles (θ20, θ21, etc.) other than the reference angle (θ22) will be called user pages hereinafter.

On the other hand, when the incident angle of the reference beam R is aligned with the reference angle θ22, the incident angle controller 30 controls the galvanometer mirror 9 and continuously varies the incident angle of the reference beam R within a predetermined angular range Δθ which includes the reference angle θ22 under constant application of the recording beam S and the reference beam. During process, the spatial modulation pattern S22 of the recording beam S for example, is not changed. Thus, as exemplified in Fig. 2, a hologram H22 which is made of one specific interference stripe pattern is recorded at a high density on page p-22 which is a page tuned in the reference angle θ22. Those pages which are tuned in the reference angle (θ22, etc.) will be called key pages hereinafter.

For reproduction, a reference beam R' is guided via the fixed mirror 8C to the reproduction galvanometer mirror 11. The reproduction galvanometer mirror 11 varies the incident angle of the reference beam R' with respect to the unit recording region T at the time of reproduction. The galvanometer mirror 11 directs the reference beam R' toward the unit recording region T from the opposite side of the hologram recording medium B as was during the recording. The reference beam R' from the reproduction galvanometer mirror 11 becomes a conjugated beam whose direction is opposite to the direction at the time of recording. The reference beam R' passes through the condenser lenses 12A, 12B and comes to the unit recording region T. During this process, the spatial light modulator 5 is controlled so as not to apply the recording beam S to the unit recording region T.

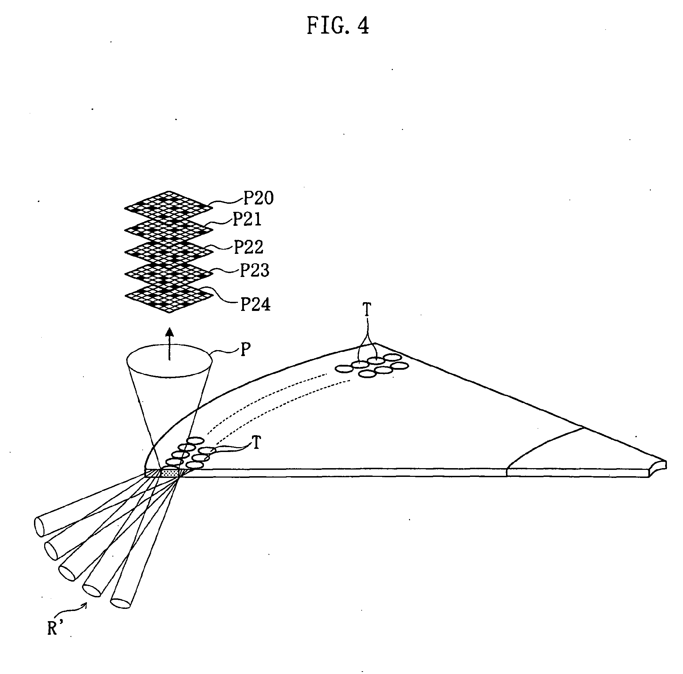

As shown in Fig. 4, upon application of the reference beam R' onto the unit recording region T, diffraction occurs in holograms H20 through H24 on a page aligned with the beam incident angle. As a result, a reproduction beam P occurs in accordance with each of the holograms H20 through H24. The reproduction beam P travels in the opposite direction to the direction of the recording beam S, passes through the second beam splitter 6, and is received by the photo detector 13 via this second beam splitter 6 (See Fig. 1). The photo detector 13, which is provided by e.g. a CMOS image sensor, receives the reproduction beam P for each of the holograms H20 through H24, and detects pixel patterns P20 through P24. The photo detector 13 as described is capable of making a scan for each part of the ID area A0 and the user area A1 of the spatial modulation patterns S20 through S24 which were described earlier (The scanning becomes possible by using the CMOS as an imaging device in a partial scanning mode). If reproduction was made without errors, the pixel patterns P20 through P24 are identical with the earlier-described spatial modulation patterns S20 through S24 which were created at the time of recording. The reproduction processor 40 reproduces the information recorded in the holograms H20 through H24 based on the pixel pattern P20 through P24.

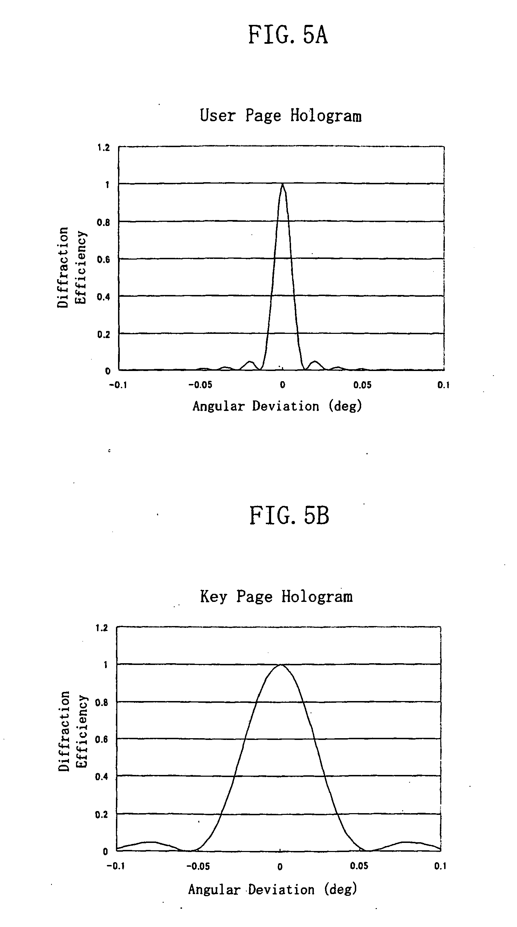

Description will now cover optical characteristics of the holograms H20 through H24. As shown in Fig. 5A, all of the holograms H20, H21, H23 and H24 which are recorded on respective user pages at the predetermined angles θ20, S21, S23 and S24 other than the reference angle θ22 have a steep curve in their diffraction efficiency with respect to angular deviation. This means that the incident angle of the reference beam R' at the time of reproduction must have an exact alignment with the incident angle at the time of recording, for the reproduction beam P to have a sufficient luminance. On the other hand, as shown in Fig. 5B, the hologram H22 which is recorded on the key page at the reference angle θ22, has a milder curve in its diffraction efficiency with respect to angular deviation than in Fig. 5A. This means that the reproduction beam P will have an appropriate luminance even when the incident angle of the reference beam R' is slightly out of alignment at the time of reproduction, since the hologram H22 is recorded at a high density.

As shown in Fig. 5A, the angular interval α in the variable control of the incident angle of the reference beam R at the time of recording is set to a specific value, or more specifically about 0.03 degrees. This is a value at which diffraction efficiency minimizes second time as the angular deviation gradually increases from zero degree. With the angular interval α being as such, the value Δθ which is a value when the incident angle of the reference beam R is continuously varied near the reference angle θ22 is set to a smaller vale than the angular interval α, i.e. Δθ<α. This arrangement serves to eliminate crosstalk between the key page p-22 which is recorded at the reference angle θ22 and its adjacent user pages i.e. p-21 and p-23. Note that the arrangement may be Δθ>α, alternatively. In this case, the reference beam incident angle cannot be varied at an equal angular interval α, yet the arrangement offers an advantage of increased tolerance in the angular error of the reference beam when reading the key page (increased error resistance).

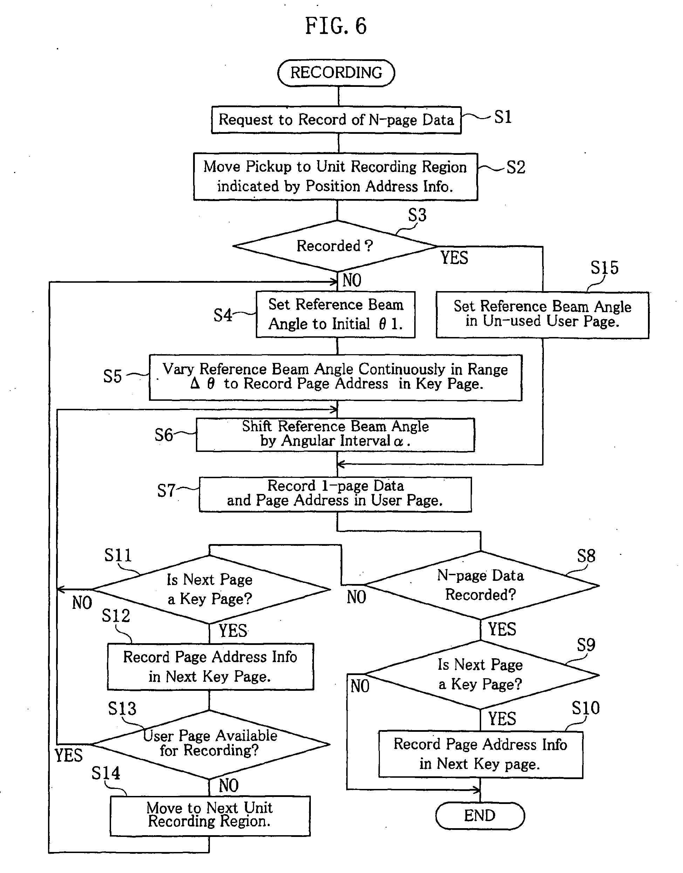

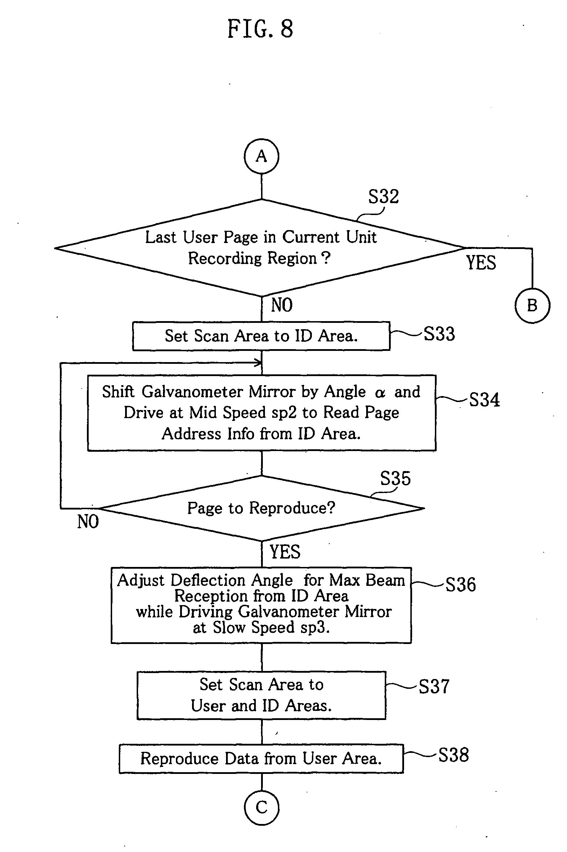

Next, description will cover a recording procedure and a reproduction procedure in the hologram recorder A, with reference to flowcharts in Fig. 6 through Fig. 8.

As shown in Fig. 6, when recording, a request for recording data for N pages comes from e.g. an unillustrated, external host computer (S1). In response to this, the microcomputer of the hologram recorder A obtains position address information and page address information which indicate where the requested data is to be recorded, based on data management information.

Then, the microcomputer moves the pick up to a unit recording region T indicated by the position address information (S2).

If the data management information indicates that the unit recording region T has no data (hologram) recorded (S3: NO), the incident angle controller 30 controls the deflection angle of the galvanometer mirror 9, thereby setting the incident angle of the reference beam R to an initial angle θ1 (S4). During this period, no application of the reference beam R or the recording beam S is made to the unit recording region T. Note that in the present embodiment, the initial angle θ1 is the reference angle.

Thereafter, the incident angle controller 30 dynamically varies the deflection angle of the galvanometer mirror 9, thereby steplessly varies the incident angle of the reference beam R within the angular range Δθ including the initial angle (reference angle) θ1. While the incident angle of the reference beam R is being varied, the reference beam R and the recording beam S are continuously applied to the unit recording region T. During this process, the recording beam S is modulated by the spatial light modulator 5 into a beam of spatial modulation pattern that only includes page address information n the ID areas A0. Thus, a key page tuned to the reference angle θ1 is formed in the unit recording region T by holography, and the page address information is recorded in the key page (S5). Alternatively, when the key page is created, the recording beam of the spatial modulation pattern may also include data which is to be recorded in the user area, so that the data is recorded together with the page address information. Such a key page has a large tolerance to the angular error of the reference beam at the time of reproduction, making possible to increase user data protection by storing prioritized data (such as index files in file systems, information added to data for redundancy, etc.) in the key page.

Next, the incident angle controller 30 varies the deflection angle of the galvanometer mirror 9 by a predetermined angle, thereby shifting the incident angle of the reference beam R by a predetermined angular interval α (S6). Specifically, the incident angle of the reference beam R is now set to the predetermined angle θ.

Then, with the incident angle of the reference beam R being maintained at the predetermined angle θ2, the reference beam R and the recording beam S are applied. During this process, the recording beam S is modulated by the spatial light modulator 5 into a beam of spatial modulation pattern that includes page address information in the ID areas A0, and a page of data as an object of recording in the user area A1. Thus, a user page tuned to the predetermined angle θ2 is formed in the unit recording region T by holography, with the page address information and a page of data recorded in the user page (S7).

Upon completion of recording the data for the N pages (S8: YES), the microcomputer checks if the next page is supposed to be a key page, based on the incident angle of the reference beam R from the data management information, etc (S9).

If the next page is a key page (S9: YES), the microcomputer has the incident angle controller 30 perform the same routine as in S4 and S5, thereby setting the incident angle of the reference beam R to the next reference angle θ22, and records page address information in the next key page (S10). Thereafter, the microcomputer finishes the series of recording procedures.

If S9 finds that the next page is a user page (S9: NO), the microcomputer finishes the recording procedures, with the next user page left as a blank page.

If S8 finds that recording of the data for the N pages is not completed (S8: NO), the microcomputer checks if the page after the next page is supposed to be a key page, based on data management information, etc. (S11).

If S11 finds that the page is a user page (S11: NO), the microcomputer brings the process back to S6. Specifically, the incident angle of the reference beam R is shifted by the predetermined angular interval α, and page address information and a page of data are recorded in the next user page.

On the other hand, if the page is a key page (S11: YES), the microcomputer makes the system perform the same routine as S10, thereby recording the page address information in the next key page (S12).

Thereafter, the microcomputer checks if there is any user page available for recording in the current unit recording region T, based on data management information, etc. (S13) .

If there is a user page available for recording in the current unit recording region (S13: YES), the microcomputer brings the process back to S6. Thus, the incident angle of the reference beam R is shifted by the predetermined angular interval α, and page address information and a page of data are recorded in the next user page.

On the other hand , if there is no user page available (S13: NO), the microcomputer moves the pick up to the next unit recording region T based on the position address information (S14), and then brings the process back to S4. Thus, the data is recorded over a plurality of unit recording regions T.

If S3 finds that data is already recorded in some user pages in the current unit recording region T, based on the data management information (S3: YES), the incident angle controller 30 controls the deflection angle of the galvanometer mirror 9, thereby setting the incident angle of the reference beam R to a predetermined angle that is tuned in a blank user page (S15), and then the process goes to S7. Thus, it is possible to record data in all user pages in a unit recording region T.

To reproduce data which has been recorded in the hologram recording medium B as described above, the following may be performed.

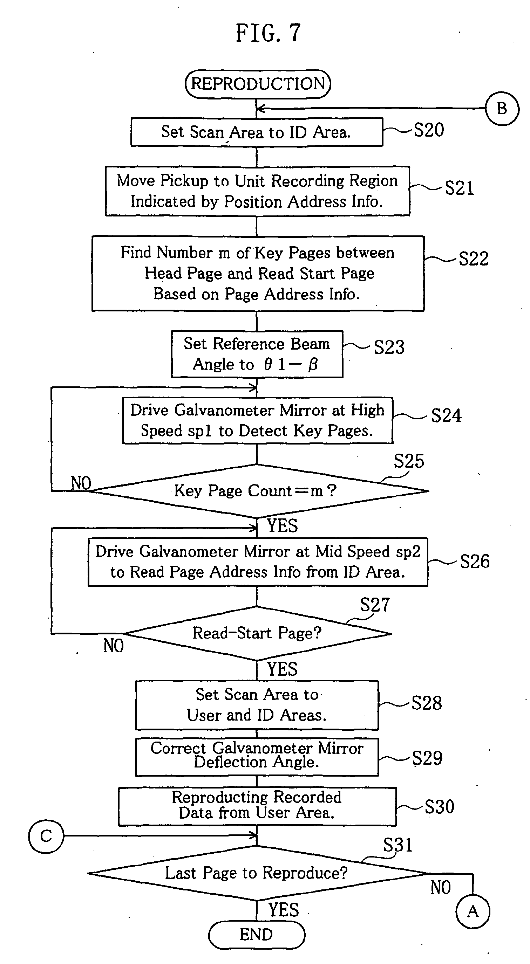

As shown in Fig. 7, a data reproduction request comes from an external host computer. In response to this, the microcomputer of the hologram recorder A obtains position address information and page address information of the requested data, based on data management information. Then, the microcomputer sets a scan area of the photo detector 13 trained upon the ID areas A0 (S20).

Thereafter, the microcomputer moves the pick up to a unit recording region T indicated by the position address information (S21).

Then, the microcomputer calculates the number m of key pages which exist between the head page and the first page for the reply in the current unit recording region T based on the page address information on the basis of data management information (S22).

After the number m of the key pages is calculated, the incident angle controller 30 controls the deflection angle of the galvanometer mirror 11, thereby setting the incident angle of the reference beam R' to an initial angle θ1-β (S23). During this process, the reference beam R' is not yet applied to the unit recording region T. Note that the incident angle of the reference beam R' is not set exactly to the initial angle θ1 but to θ1-β: This is to compensate for a certain amount of error in the incident angle off the original setting at the time of recording which is anticipated from shrinkage of the medium when the laser beam is applied, wavelength variation, tilt of the medium, setting variation of the deflection angle of the galvanometer mirror 11, etc.

Upon completion of all preparations as described above, the reference beam R' is applied to the unit recording region T. The incident angle controller 30 varies the galvanometer mirror 11 steplessly at a high speed sp1. During this process, a reproduction beam P of a sufficient luminance tuned in the key page occurs in the unit recording region T as described earlier with reference to Fig. 5B if an alignment is achieved between the incident angle of the reference beam R' and the reference angle used at the time of recording within a certain tolerance range. Thus, the photo detector 13 receives the reproduction beam P which is tuned in the key page, in the scan area which is trained upon the ID areas A0, and based on the beam reception signal from the photo detector 13, the reproduction processor 40 detects the key page (S24). In this process, it is possible to increase the frame rate (the number of pages to which imaging is made per unit time) by limiting the scan area of the photo detector 13 to the ID area A0. In this case, imaging while varying the incident angle of the reference beam R' at the high sp1 is impossible for user pages since an angle range of the reference beam R' from which diffraction signals can be obtained is narrow in user pages and imaging device does not have a competent bandwidth. However, key pages have a wide angle range for the reference beam R' to work, so it is possible to do imaging by varying the incident angle of the reference beam R' at the high speed sp1.

When the number of key page detections thus obtained matches with the number m of the pages (S25: YES), the microcomputer keeps the reference beam R' applied on the unit recording region T whereas the incident angle controller 30 operates the galvanometer mirror 11 at a middle speed sp2, down from the high speed sp1. During this process, the photo detector 13 receives a reproduction beam P which is tuned in the user page; and since the reproduction beam is received by a part of scan area which is trained upon the ID areas A0, the obtained reproduction beam has a sufficient luminance. Thus, the reproduction processor 40 reads page address information from the ID areas A0 based on the beam reception signal from the photo detector 13 (S26).

If the obtained page address information indicates that the user page which is accessed currently is the reproduction start page (S27: YES), the microcomputer sets the scan area of the photo detector 13 to train upon the ID areas A0 and the user area A1 (S28).

Thereafter, the microcomputer causes the incident angle controller 30 to correct the deflection angle of the galvanometer mirror 11 (S29). Specifically, this means that a correction value is obtained as a difference between the deflection angle of the galvanometer mirror 9 at the time of recording and the current deflection angle of the galvanometer mirror 11, and that an deflection angle of the galvanometer mirror 11 at which the amount of beam reception becomes largest is obtained based on this correction value.

Thus, the photo detector 13 receives a reproduction beam P tuned in the user page, and outputs a corresponding beam reception signal. Hence, the reproduction processor 40 can reliably reproduction the data recorded in the user area A1, based on the beam reception signal from the photo detector 13 (S30).

Thereafter, the microcomputer checks if the currently accessed user page is the last page to be reproduced, based on the obtained page address information (S31). If the current page is the last user page (S31: YES), the microcomputer finishes the sequence of reproduction process.

If S31 finds there is a remaining user page(s) to be reproduced (S31: NO), the microcomputer checks if the current user page is the last user page in the current unit recording region T (S32).

If the current user page is not the last user page (S32: NO), the microcomputer sets the scan area of the photo detector 13 again to the ID areas A0 (S33).

Thereafter, the incident angle controller 30 operates the galvanometer mirror 11 at a middle speed sp2 so that the incident angle of the reference beam R' will shift by a predetermined interval α. When the deflection angle of the galvanometer mirror 11 attains a certain angle, the reference beam R' is applied again to the unit recording region T. Thus, the photo detector 13 receives a reproduction beam P which is tuned in the user page, with a part of its scan area trained upon the ID areas A0, and the reproduction processor 40 reads the page address information from the ID areas A0 based on the beam reception signal from the photo detector 13 (S34).

If the obtained page address information indicates that the user page which is accessed currently is the user page to be reproduced next (S35: YES), the microcomputer makes fine tuning of the deflection angle for maximum amount of beam reception in the scan area trained upon the ID area A0 of the photo detector 13 while operating the galvanometer mirror 11 at a low speed sp3 (S36) . As has been described with reference to Fig. 5A, a reproduction beam P tuned in the user page and thus having a sufficient luminance cannot be obtained during this process unless the incident angle of the reference beam R' is exactly equal to the predetermined angle used at the time of recording. However, since the operation speed of the galvanometer mirror 11 is the slowest sp3, it is possible to make an exact tuning by making fine adjustments on the incident angle of the reference beam R'.

Then, the microcomputer trains the scan area of the photo detector 13 again upon the ID areas A0 and the user area A1 (S37).

As a result, the photo detector 13 efficiently receives the reproduction beam P which is tuned in the user page, and outputs equivalent beam reception signal. Thus, the reproduction processor 40 can accurately reproduction the data recorded in the user area A1, based on the beam reception signal from the photo detector 13 (S38). Thereafter,the microcomputer brings the process back to S31.

If S35 finds that the currently accessed user page is not a user page to be reproduced next (S35: NO), the microcomputer brings the process back to S34, to repeat the sequence of procedures.

If S32 find that the current page is the last user page (S32: YES), the microcomputer brings the process back to S20, to repeat the sequence of procedures.

If S27 finds that the currently accessed user page is not the first page to be reproduced (S27: NO), the microcomputer brings the process back to S26.

If S25 finds that the number of key page detections is smaller than the number m of pages (S25: NO), the microcomputer brings the process back to S24.

According to the reproduction process described, it is possible to scan and detect key pages quickly while operating the galvanometer mirror 11 at a relatively high speed, and thereby making quick access to a target user pages.

Therefore, according to the hologram recorder A provided by the present embodiment, it is possible to read target record data accurately and quickly at the time of reproduction, and by lowering reproduction conditions, it is also possible to offer such an advantage as increased reproduction speed.

The hologram recorder A according to the above embodiment conducts variable control of the reference beam incident angle in order to achieve multiple recording. There are also other optical methods of making multiple recording, under the same optical principle as varying the incident angle. Such methods include variable control of a laser beam wavelength, and variable control of a speckle size after the reference beam is converted into a speckle beam (in other words, "speckle-modulated"). The same advantages can be enjoyed from these other embodiments of the hologram recorder which use multiple recording method based upon variable control of wavelength or variable control of speckle size, by using the same recording and reproduction processes as used in the above-described embodiment.

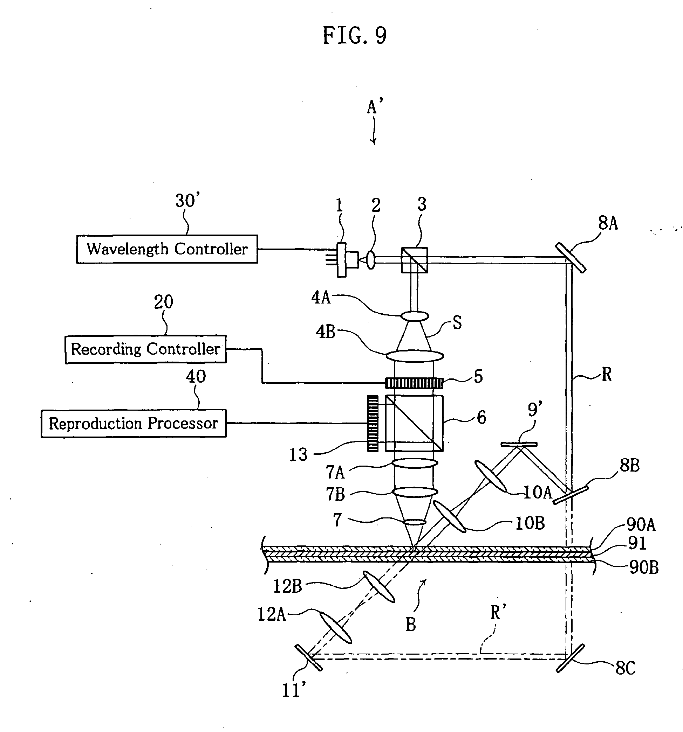

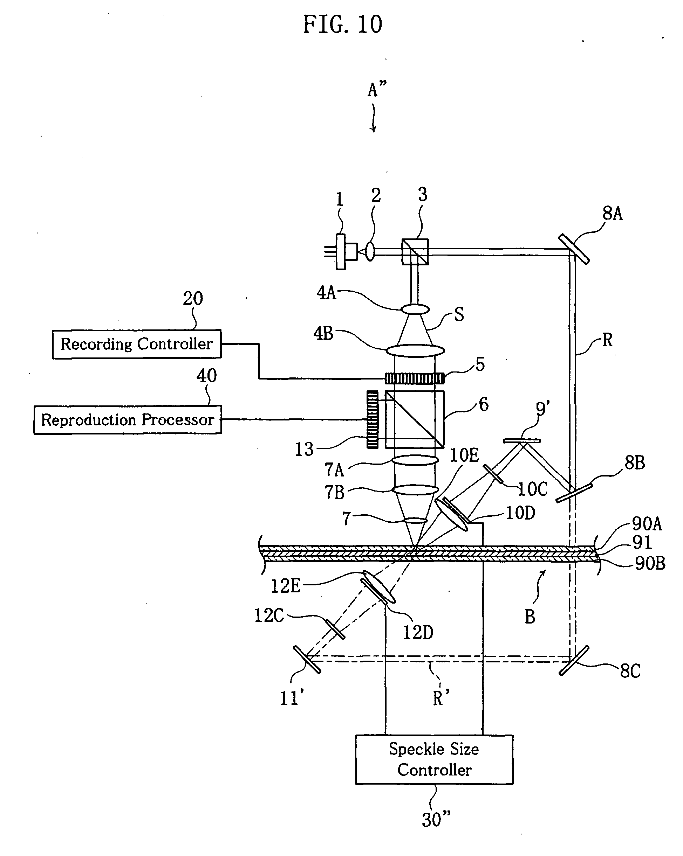

Fig. 9 and Fig. 10 show these other embodiments of the hologram recorder according to the present invention. Note that in describing these embodiments, those components which are the same as or similar to those in the previous embodiment will be indicated by the same reference codes, and description will be made only on differences.

A hologram recorder A' in Fig. 9 is configured for multiple recording through variable control of laser beam wavelength, and includes a beam wavelength controller 30'. Specifically, the beam wavelength of the laser beam which comes from a light source 1 is variably controlled by the beam wavelength controller 30'. Note that the embodiment described earlier includes galvanometer mirrors 9, 11 for variable control of the incident angles of reference beams R, R'; however, in the hologram recorder A' according to the present embodiment, these will be replaced by fixed mirrors 9', 11'.

When recording is performed in the above hologram recorder A' in which multiple recording is made by wavelength variable control, application of the recording beam S and the reference beam R is made while steplessly varying the beam wavelength of the laser beam to create a key page in a unit recording region T, and page address information can be recorded in this key page. Diffraction efficiency in key pages is expressed by a curve similar to the one in Fig. 5B, with the horizontal axis representing the wavelength deviation. On the other hand, a user page is created in the unit recording region T when the laser beam wavelength is shifted by a predetermined wavelength and the recording beam S and the reference beam R are applied at a constant wavelength after the shift. Data as an object of recording and page address information can be recorded in this user page. Diffraction efficiency in user page is expressed by a curve similar to the one in Fig. 5A, with the horizontal axis representing the wavelength deviation. Therefore, by utilizing the same reproduction procedures for reproduction process as in the embodiment described earlier, it becomes possible to achieve increase in reproduction speed.

Fig. 10 shows a hologram recorder A" in which the reference beams R, R' are converted into speckle beams and their speckle size is variably controlled for multiple recording. The recorder includes a speckle size controller 30". Specifically, the reference beams R, R' from the fixed mirrors 9', 11' are converted by the diffuser plates 10C, 12C into speckle beams, and these reference beams R, R' in the form of speckle beams are applied to the unit recording region T via liquid crystal filters 10D, 12D and object lenses 10E, 12E. The speckle size is dependent upon the numerical aperture of the object lenses 10E, 12E. Therefore, as the speckle size controller 30" varies a voltage which is applied to the liquid crystal filters 10D, 12D, the numerical aperture of the object lenses 10E, 12E varies, and the speckle size is varied accordingly. Thus, the speckle size controller 30" can control the speckle size.

When recording is performed in the above hologram recorder A" in which multiple recording is made by speckle size variable control, application of the recording beam S and the reference beam R is made while steplessly varying the speckle size to create a key page in a unit recording region T, and page address information can be recorded in this key page. Diffraction efficiency in key pages is expressed by a curve similar to the one in Fig. 5B, with the horizontal axis representing dimensional deviation of the speckle size. On the other hand, when the recording beam S and the reference beam R are applied while keeping a constant speckle size after being shifted by a predetermined wavelength, a user page is created in the unit recording region T. Data as an object of recording and page address information can be recorded in this user page. Diffraction efficiency in user pages is expressed by a curve similar to the one in Fig. 5A, with the horizontal axis representing the dimensional deviation of the speckle size. Therefore, by utilizing the same reproduction procedures for reproduction process as in the embodiment described earlier, it becomes possible to achieve increase in reproduction speed.

## Claims

1. A hologram recorder for multiple holographic recording, the recorder comprising:
an optical system (1-12) for applying a recording beam (S) and a reference beam (R) to a unit recording region (T) of a hologram recording medium (B), the recording beam (S) being modulated in accordance with information to be recorded, the reference beam (R) having a same wavelength as the recording beam (S); and
an incident angle controller (30) for adjusting an incident angle of one of the recording beam (S) and the reference beam (R) to set angles (θ20-θ24), the adjustment of the incident angle to a selected one of the set angles (θ20-θ24) enabling holographic recording for a page;
wherein the unit recording region (T) is adapted to record a plurality of pages which include a key page (p-22) and a user page,
wherein the set angles (θ20-θ24) include at least one reference angle (θ22) associated with the key page (p-22) and a plurality of predetermined set angles (θ20, θ21, θ23, θ24) each associated with a user page,
wherein when recording the key page (p-22), the incident angle controller (30) causes the incident angle to continuously vary within a predetermined angular range (Δθ) containing the reference angle (θ22), the continuous variation of the incident angle being performed during irradiation of the unit recording region (T) with the recording beam (S) and the reference beam (R), while when recording a user page, during irradiation of the unit recording region (T) with the recording beam (S) and the reference beam (R), the incident angle controller (3) keeps the incident angle set to one of the predetermined set angles (θ20, θ21, θ23, θ24) associated with a user page.

2. The hologram recorder according to claim 1, wherein the angular range (Δθ) is shorter than an interval (α) between the set angles (θ20-θ24).

3. The hologram recorder according to claim 1, wherein address information necessary for access is recorded in the page by holographic recording.

4. A hologram recorder for multiple holographic recording, the recorder comprising:
an optical system (1-12) for applying a recording beam (S) and a reference beam (R) to a unit recording region (T) of a hologram recording medium (B), the recording beam (S) being modulated in accordance with information to be recorded, the reference beam (R) having a beam wavelength same as a beam wavelength of the recording beam (S); and
a wavelength controller (30') for adjusting the beam wavelength to set wavelengths, the adjustment of the beam wavelength to a selected one of the set wavelengths enabling holographic recording for a page;
wherein the unit recording region (T) is adapted to record a plurality of pages which include a key page (p-22) and a user page,
wherein the set wavelengths include at least one reference wavelength associated with the key page (p-22) and a plurality of predetermined set wavelengths each associated with a user page,
wherein when recording the key page (p-22), the wavelength controller (30') causes the beam wavelength to continuously vary within a predetermined wavelength range containing the reference wavelength, the continuous variation of the beam wavelength being performed during irradiation of the unit recording region (T) with the recording beam (S) and the reference beam (R), while when recording a user page, during irradiation of the unit recording region (T) with the recording beam (S) and the reference beam (R), the wavelength controller (30') keeps the beam wavelength seal to one of the predetermined set wavelengths associated with a user page.

5. A hologram recorder for multiple holographic recording, the recorder comprising:
an optical system (1-12) for applying a recording beam (S) and a reference beam (R) to a unit recording region (T) of a hologram recording medium (B), the recording beam (S) being modulated in accordance with information to be recorded, the reference beam (R) having a wavelength same as a wavelength of the recording beam (S) and being speckle-modulated; and
a speckle size controller (30") for adjusting a speckle size of the reference beam (R) to set sizes, the adjustment of the speckle size to a selected one of the set sizes enabling holographic recording for a page;
wherein the unit recording region (T) is adapted to record a plurality of pages which include a key page (p-22) and a user page,
wherein the set sizes include at least one reference size associated with the key page (p-22) and a plurality of predetermined set sizes each associated with a user page,
wherein when recording the key page (p-22), the speckle size controller (30") causes the speckle size to continuously vary within a predetermined size range containing the reference size, the continuous variation of the speckle size being performed during irradiation of the unit recording region (T) with the recording beam (S) and the reference beam (R), while when recording a user page, during irradiation of the unit recording region (T) with the recording beam (S) and the reference beam (R), the speckle size controller (30") keeps the speckle size set to one of the predetermined set sizes associated with a user page.

6. A hologram recording method for multiple holographic recording, the method comprising the steps of:
applying a recording beam (S) and a reference beam (R) to a unit recording region (T) of a hologram recording medium (B), the recording beam (S) being modulated in accordance with information to be recorded, the reference beam (R) having a same wavelength as the recording beam (S);
adjusting an incident angle of one of the recording beam (S) and the reference beam (R) to set angles (θ20-θ24); and
recording a hologram (H20-H24) for a page every time the incident angle is adjusted to one of the set angles (θ20-θ24);
wherein the unit recording region (T) is adapted to record a plurality of pages which include a key page (p-22) and a user page,
wherein the set angles (θ20-θ24) include at least one reference angle (θ22) associated with the key page (p-22) and a plurality of predetermined set angles (θ20, θ21, θ23, θ24) each associated with a user page,
wherein when recording the key page (p-22), the incident angle is caused to continuously vary within a predetermined angular range (Δθ) containing the reference angle (θ22), the continuous variation of the incident angle being performed during irradiation of the unit recording region (T) with the recording beam (S) and the reference beam (R), while when recording a user page, during irradiation of the unit recording region (T) with the recording beam (S) and the reference beam (R), the incident angle is kept set to one of the predetermined set angles (θ20, θ21, θ23, θ24) associated with a user page.

7. A hologram recording method for multiple homographic recording, the method comprising the steps of:
applying a recording beam (S) and a reference beam (R) to a unit recording region (T) of a hologram recording medium (B), the recording beam (S) being modulated in accordance with information to be recorded, the reference beam (R) having a beam wavelength same as a beam wavelength of the recording beam (S);
adjusting the beam wavelength of the recording beam (S) and the reference beam (R) to set wavelengths; and
recording a hologram (H20-H24) for a page every time the beam wavelength is adjusted to one of the set wavelength;
wherein the unit recording region (T) is adapted to record a plurality of pages which include a key page (p-22) and a user page,
wherein the set wavelengths include at least one reference wavelength associated with the key page (p-22) and a plurality of predetermined set wavelengths each associated with a user page,
wherein when recording the key page (p-22), the beam wavelength is caused to continuously vary within a predetermined wavelength range containing the reference wavelength, the continuous variation of the beam wavelength being performed during irradiation of the unit recording region (T) with the recording beam (S) and the reference beam (R), while when recording a user page, during irradiation of the unit recording region (T) with the recording beam (S) and the reference beam (R), the beam wavelength is kept set to one of the predetermined set wavelengths associated witch a user page.

8. A hologram recording method for multiple holographic recording, the method comprising the steps of:
applying a recording beam (S) and a reference beam (R) to a unit recording region (T) of a hologram recording medium (B), the recording beam (S) being modulated in accordance with information to be recorded, the reference beam (R) having a wavelength same as a wavelength of the recording beam (S) and being speckle-modulated;
adjusting a speckle size of the reference beam (R) to set sizes; and
recoding a hologram (H20-H24) for a page every time the speckle size is adjusted to one of the set sizes;
wherein the unit recording region (T) is adapted to record a plurality of pages which include a key page (p-22) and a user page,
wherein the set sizes include at least one reference size associated with the key page (p-22) and a plurality of predetermined set sizes each associated with a user page,
wherein when recording the key page (p-22), the speckle size is caused to continuously vary within a predetermined size range containing the reference size, the continuous variation of the speckle size being performed during irradiation of the unit recording region (T) with the recording beam (S) and the reference beam (R), while when recording a user page, during irradiation of the unit recording region (T) with the recording beam (S) and the reference beam (R), the speckle size is kept set to one of the predetermined set sizes associated with a user page.

## Patentansprüche

1. Hologrammaufzeichnungsgerät zur mehrfachen holographischen Aufzeichnung, welches Aufzeichnungsgerät umfasst:
ein optisches System (1-12) zum Anwenden eines Aufzeichnungsstrahls (S) und eines Referenzstrahls (R) auf eine Einheitsaufzeichnungsregion (T) eines Hologrammaufzeichnungsmediums (B), wobei der Flufzeichnungsstrahl (S) gemäß aufzuzeichnenden Informationen moduliert wird und der Referenzstrahl. (R) dieselbe Wellenlänge wie der Aufzeichnungsstrahl (S) hat; und
einen Einrallswinkelcontroller (30) zum Einstellen eines Einfallswinkels von einem des Aufzeichnungsstrahls (S) und des Referenzstrahls (R) auf festgelegte Winkel (θ20-θ24), welche Einstellung des einfallswinkels auf einen selektierten der festgelegten Winkel (θ20-θ24) die holographische Aufzeichnung für eine Seite ermöglicht;
bei dem die Einheitsaufzeichnungsregion (T) dafür ausgelegt ist, um eine Vielzahl von Seiten aufzuzeichnen, die eine Schlüsselseite (p-22) und eine Nutzerseite enthalten,
bei dem die festgelegten Winkel (θ20-θ24) wenigstens einen Referenzwinkel (θ22) enthalten, der der Schlüsselseite (p-22) zugeordnet ist, sowie eine Vielzahl von vorbestimmten festgelegten Winkeln (θ20, θ21, θ23, θ24), die jeweils einer Nutzerseite zugeordnet sind,
bei dem dann, wenn die Schlüsselseite (p-22) aufgezeichnet wird, der Einfallswinkelcontroller (30) bewirkt, dass der Einfallswinkel innerhalb eines vorbestimmten Winkelbereichs (Δθ), der den Referenzwinkel (θ22) enthält, kontinuierlich variiert, welches kontinuierliche Variieren des Einfallswinkels während der Bestrahlung der Einheitsaufzeichnungsregion (T) mit dem Aufzeichnungsstrahl (S) und dem Referenzstrahl (R) erfolgt, währenddem dann, wenn eine Nutzerseite aufgezeichnet wird, während der Bestrahlung der Einhei.tsaufzeichnungsregion (T) mit dem Aufzeichnungsstrahl (S) und dem Referenzstrahl (R) der Einfallswinkelcontroller (30) den Einfallswinkel beibehält, der auf einen der vorbestimmten festgelegten Winkel (θ20, θ21, θ23, θ24) festgelegt ist, die einer NuLzerseite zugeordnet sind.

2. Hologrammaufzeichnungsgerät nach Anspruch 1, bei dem der Winkelbereich (Δθ) kürzer als ein Intervall (α) zwischen den festgelegten Winkeln (θ20-θ24) ist.

3. Hologrammaufzeichnungsgerät nach Anspruch 1, bei dem Adresseninformationen, die zum Zugriff erforderlich sind, durch holographische Aufzeichnung in der Seite aufgezeichnet werden.

4. Hologrammaufzeichnungsgerät zur mehrfachen holographischen Aufzeichnung, welches Aufzeichnungsgerät umfasst:
ein optisches System (1-12) zum Anwenden eines Aufzeichnungsstrahls (S) und eines Referenzstrahls (R) auf eine Einheitsaufzeichnungsregion (T) eines Hologrammaufzeichnungsmediums (B), wobei der Aufzeichnunqsstrahl (S) gemäß aufzuzeichnenden Informationen moduliert wird und der Referenzstrahl (R) eine Strahlwellenlänge hat, die dieselbe wie eine Strahlwellenlänge des Aufzeichnungsstrahls (S) ist; und
einen Wellenlängencontroller (30') zum Einstellen der Strahlwellenlänge auf festgelegte Wellenlängen, welche Einstellung der Strahlwellenlänge auf eine selektierte der festgelegten Wellenlängen die holographische Aufzeichnung für eine Seite ermöglicht;
bei dem die Einheitsaufzeichnungsregi.on (T) dafür ausgelegt ist, um eine Vielzahl von Seiten aufzuzeichnen, die eine Schlüsselseite (p-22) und eine Nutzerseite enthalten,
bei dem die festgelegten Wellenlängen wenigstens eine Referenzwellenlänge enthalten, die der Schlüsselseite (p-22) zugeordnet ist, sowie eine Vielzahl von vorbestimmten festgelegten Wellenlängen, die jeweils einer Nutzerseite zugeordnet sind,
bei dem dann, wenn die Schlüsselseite (p-22) aufgezeichnet wird, der Wcllenlängencontroller (30') bewirkt, dass die Strahlwellenlänge innerhalb eines vorbestimmten Wellenlängenbereichs, der die Referenzwellenlänge enthält, kontinuierlich variiert, welches kontinuierliche Variieren der SLrahlwellenlänge während der Bestrahlung der Einheitsaufzeichnungsregion (T) mit dem Aufzeichnungsstrahl (S) und dem Referenzstrahl (R) erfolgt, währenddem dann, wenn eine Nutzerseite aufgezeichnet wird, während der Bestrahlung der Einheitsaufzeichnungsregion (T) mit dem Aufzeichnungsstrahl (S) und dem Referenzstrahl (R) der Wellenlängencontroller (30') die Strahlwellenlänge beibehält, die auf eine der vorbestimmten festgelegten Wellenlängen festgelegt ist, die einer Nutzerseite zugeordnet sind.

5. Hologrammaufzeichnungsgerät zur mehrfachen holographischen Aufzeichnung, welches Aufzeichnungsgerät umfasst:
ein optisches System (1-12) zum Anwenden eines Aufzeichnungsstrahls (S) und eines Referenzstrahls (R) auf eine Einheitsaufzeichnungsregion (T) eines Hologrammaufzeichnurigsmediums (B), wobei der Aufzeichnungsstrahl (S) gemäß aufzuzeichnenden Informationen moduliert wird und der Referenzstrahl (R) eine Wellenlänge hat, die dieselbe wie eine Wellenlänge des Aufzeichnungsstrahls (S) ist, und einer Speckle-Modulation unterzogen wird; und
einen Speckle-Größencontroller (30") zum Einstellen einer Speckle-Größe des Referenzstrahls (R) auf festgelegte Größen, welche Einstellung der Speckle-Größe auf eine selektierte der festgelegten Größen die holographische Aufzeichnung für eine Seite ermöglicht;
bei dem die Einheitsaufzeichnungsregion (T) dafür ausgelegt ist, um eine Vielzahl von Seiten aufzuzeichnen, die eine Schlüsselseite (p-22) und eine Nutzerseite enthalten,
bei dem die festgelegten Größen wenigstens eine Referenzgröße enthalten, die der Schlüsselseite (p-22) zugeordnet ist, sowie eine Vielzahl von vorbestimmten festgelegten Größen, die jeweils einer Nutzerseite zugeordnet sind,
bei dem dann, wenn die Schlüsselseite (p-22) aufgezeichnet wird, der Speckle-Größencontroller (30") bewirkt, dass die Speckle-Größe innerhalb eines vorbestimmten Größenbereichs, der die Referenzgröße enthält, kontinuierlich variiert, welches kontinuierliche Variieren der Speckle-Größe während der Bestrahlung der Einheitsaufzeichnungsregion (T) mit dem Aufzeichnungsstrahl (S) und dem Referenzstrahl (R) erfolgt, währenddem dann, wenn eine Nutzerseite aufgezeichnet wird, während der Bestrahlung der Einheitsaufzeichnungsregion (T) mit dem Aufzeichnungsstrahl (S) und dem Referenzstrahl (R) der Speckle-Größencontroller (30") die Speckle-Größe beibehält, die auf eine der vorbestimmten festgelegten Größen festgelegt ist, die einer Nutzerseite zugeordnet sind.

6. Hologrammaufzeichnungsverfahren zur mehrfachen holographischen Aufzeichnung, welches Verfahren die Schritte umfasst:
Anwenden eines Aufzeichnungsstrahls (S) und eines Referenzstrahls (R) auf eine Einheitsaufzeiohnungsregion (T) eines Hologrammaufzeichnungsmediums (B), wobei der Aufzeichnungsstrahl (S) gemäß aufzuzeichnenden Informationen moduliert wird und der Referenzstrahl (R) dieselbe Wellenlänge wie der Aufzeichnungsstrahl (S) hat;
Einstellen eines Einfallswinkels von einem des Aufzeichnungsstrahls (S) und des Referenzstrahls (R) auf fesLgelege Winkel (θ20-θ24); und
Aufzeichnen eines Hologramms (H20-H24) für eine Seite, immer wenn der Einfallswinkel auf einen der festgelegten Winkel (θ20-θ24) eingestellt wird;
bei dem die Einheitsaufzeichnungsregion (T) dafür ausgelegt ist, um eine Vielzahl von Seiten aufzuzeichnen, die eine Schlüsselseite (p-22) und eine Nutzerseite enthalten,
bei dem die festgelegten Winkel (θ20-θ24) wenigstens einen Referenzwinkel (θ22) enthalten, der der Schlüsselseite (p-22) zugeordnet ist, sowie eine Vielzahl von vorbestimmten festgelegten Winkeln (θ20, θ21, θ23, θ24), die jeweils einer Nutzerseite zugeordnet sind,
bei dem dann, wenn die Schlüsselseite (p-22) aufgezeichnet wird, bewirkt wird, dass der Einfallswinkel innerhalb eines vorbestimmten Winkelbereichs (Δθ), der den Referenzwinkel (θ22) enthält, kontinuierlich variiert, welches kontinuierliche Variieren des Einfallswinkels während der Bestrahlung der Einheitsaufzeichnunqsregion (T) mit dem Aufzeichnungsstrahl (S) und dem Referenzstrahl (R) erfolgt, währenddem dann, wenn eine Nutzerseite aufgezeichnet wird, während der Bestrahlung der Einhcitsaufzeichnungsregion (T) mit dem Aufzeichnungsstrahl (S) und dem Referenzstrahl (R) der Einfallswinkel beibehalten wird, der auf einen der vorbestimmten festgelegten Winkel (θ20, θ21, θ23, θ24) festgelegt ist, die einer Nutzerseite zugeordnet sind.

7. Hologrammaufzeichnungsverfahren zur mehrfachen holographischen Aufzeichnung, welches Verfahren die Schritte umfasst:
Anwenden eines Aufzeichnunqsstrahls (S) und eines Referenzstrahls (R) auf eine Einheitsaufzeichnungsregion (T) eines Hologrammaufzeichnungsmediums (B), wobei der Aufzeichnungsstrahl (S) gemäß aufzuzeichnenden Informationen moduliert wird und der Referenzstrahl (R) eine Strahlwellenlänge hat, die dieselbe wie eine Strahlwellenlänge des Aufzeichnungsstrahls (S) ist;
Einstellen der Strahlwellenlänge des Aufzeichnungsstrahls (S) und des Referenzstrahls (R) auf festgelegte Wellenlängen; und
Aufzeichnen eines Hologramms (H20-H24) für eine Seite, immer wenn die Strahlwellenlänge auf eine der festgelegten Wellenlängen eingestellt wird;
bei dem die Einheitsaufzeichnungsregion (T) dafür ausgelegt ist, um eine Vielzahl von Seiten aufzuzeichnen, die eine Schlüsselseite (p-22) und eine Nutzerseite enthalten,
bei dem die festgelegten Wellenlängen wenigstens eine Referenzwellenlänge enthalten, die der Schlüsselseite (p-22) zugeordnet ist, sowie eine Vielzahl von vorbestimmten festgelegten Wellenlängen, die jeweils einer Nutzerseite zugeordnet sind,
bei dem dann, wenn die Schlüsselseite (p-22) aufgezeichnet wird, bewirkt wird, dass die Strahlwellenlänge innerhalb eines vorbestimmten Wellenlängenbereichs, der die Referenzwellenlänge enthält, kontinuierlich variiert, welches kontinuierliche Variieren der Strahlwellenlänge während der Bestrahlung der Einheitsaufzeichnungsrcgion (T) mit dem Aufzeichnungsstrahl (S) und dem Referenzstrahl (R) erfolgt, währenddem dann, wenn eine Nutzerseite aufgezeichnet wird, während der Bestrahlung der Einheitsaufzeichnungsregion (T) mit dem Aufzeichnungsstrahl (S) und dem Referenzstrahl (R) die Strahlwellenlänge beibehalten wird, die auf eine der vorbestimmten festgelegten Wellenlängen festgelegt ist, die einer Nutzerseite zugeordnet sind.

8. Hologrammaufzeichnungsverfahren zur mehrfachen holographischen Aufzeichnung, welches Verfahren die Schritte umfasst:
Anwenden eines Aufzeichnungsstrahls (S) und eines Referenzstrahls (R) auf eine Einheitsaufzeichnungsregion (T) eines Hologrammaufzeiehnungsmediums (B), wobei der Aufzeichnungsstrahl (S) gemäß aufzuzeichnenden Informationen moduliert wird und der Referenzstrahl (R) eine Wellenlänge hat, die dieselbe wie eine Wellenlänge des Aufzeichnungsstrahls (S) ist, und einer Speckle-Modulation unterzogen wird;
Einstellen einer Speckle-Größe des Referenzstrahls (R) auf festgelegte Größen; und
Aufzeichnen eines Hologramms (H20-H24) für eine Seite, immer wenn die Speckle-Gröfse auf eine der festgelegten Größen eingestellt wird;
bei dem die Einheitsaufzeichnungsregion (T) dafür ausgelegt ist, um eine Vielzahl von Seiten aufzuzeichnen, die eine Schlüsselseite (p-22) und eine Nutzerseite enthalten,
bei dem die festgelegten Größen wenigstens eine Referenzgröße enthalten, die der Schlüsselseite (p-22) zugeordnet list, sowie eine Vielzahl von vorbestimmten festgelegten Größen, die jeweils einer Nutzerseite zugeordnet sind,
bei dem dann, wenn die Schlüsselseite (p-22) aufgezeichnet wird, bewirkt wird, dass die Speckle-Große innerhalb eines vorbestimmten Größenbereichs, der die Referenzgröße enthält, kontinuierlich variiert, welches kontinuierliche Variieren der Speckle-Größe während der Bestrahlung der Einheitsaufzeichnungsregion (T) mit dem Aufzeichnungsstrahl (S) und dem Referenzstrahl (R) erfolgt, währenddem dann, wenn eine Nutzerseite aufgezeichnet wird, während der Bestrahlung der Einheitsaufzeichnungsregion (T) mit dem Aufzeichnungsstrahl (S) und dem Referenzstrahl (R) die Speckle-Größe beibehalten wird, die auf eine der vorbestimmten festgelegten Größen festgelegt ist, die einer Nutzerseite zugeordnet sind.

## Revendications

1. Enregistreur d'hologramme pour enregistrement holographique multiple, l'enregistreur comprenant :
un système optique (1-12) pour appliquer un faisceau d'enregistrement (S) et un faisceau de référence (R) à une région d'enregistrement d'unité (T) d'un support d'enregistrement d'hologramme (B), le faisceau d'enregistrement (S) étant modulé en fonction d'informations à enregistrer, le faisceau de référence (R) ayant la même longueur d'onde que le faisceau d'enregistrement (S) ; et
un contrôleur d'angle d'incidence (30) pour régler à des angles fixés (θ20-θ24) l'angle d'incidence d'un faisceau parmi le faisceau d'enregistrement (S) et le faisceau de référence (R), le réglage de l'angle d'incidence à un angle sélectionné parmi les angles fixés (θ20-θ24) permettant l'enregistrement holographique pour une page ;
dans lequel la région d'enregistrement d'unité (T) est adaptée à enregistrer une pluralité de pages incluant une page clé (p-22) et une page utilisateur,
dans lequel les angles fixés (θ20-θ24) comportent au moins un angle de référence (θ22) associé à la page clé (p-22) et une pluralité d'angles fixés prédéterminés (θ20, θ21, θ23, θ24) associés chacun à une page utilisateur,
dans lequel, lors de l'enregistrement de la page clé (p-22), le contrôleur d'angle d'incidence (30) fait varier en continu l'angle d'incidence dans une plage angulaire prédéterminée (Δθ) contenant l'angle de référence (θ22), la variation continue de l'angle d'incidence étant effectuée durant l'irradiation de la région d'enregistrement d'unité (T) avec le faisceau d'enregistrement (S) et le faisceau de référence (R), tandis que lors de l'enregistrement d'une page utilisateur, durant l'irradiation de la région d'enregistrement d'unité (T) avec le faisceau d'enregistrement (S) et le faisceau de référence (R), le contrôleur d'angle d'incidence (30) maintient l'angle d'incidence fixé à l'un des angles fixés prédéterminés (θ20, θ21, θ23, θ24) associé à une page utilisateur.

2. Enregistreur d'hologramme selon la revendication 1, dans lequel la plage angulaire (Δθ) est plus courte que l'intervalle (α) entre les angles fixés (θ20-θ24).

3. Enregistreur d'hologramme selon la revendication 1, dans lequel les informations d'adresse nécessaires pour l'accès sont enregistrées dans la page par un enregistrement holographique.

4. Enregistreur d'hologramme pour enregistrement holographique multiple, l'enregistreur comprenant :
un système optique (1-12) pour appliquer un faisceau d'enregistrement (S) et un faisceau de référence (R) à une région d'enregistrement d'unité (T) d'un support d'enregistrement d'hologramme (B), le faisceau d'enregistrement (S) étant modulé en fonction d'informations à enregistrer, le faisceau de référence (R) ayant la même longueur d'onde de faisceau que la longueur d'onde de faisceau du faisceau d'enregistrement (S) ; et
un contrôleur de longueur d'onde (30') pour régler la longueur d'onde de faisceau à des longueurs d'onde fixées, le réglage de la longueur d'onde de faisceau à une longueur d'onde sélectionnée parmi les longueurs d'onde fixée permettant l'enregistrement holographique pour une page ;
dans lequel la région d'enregistrement d'unité (T) est adaptée à enregistrer une pluralité de pages incluant une page clé (p-22) et une page utilisateur,
dans lequel les longueurs d'onde fixées comportent au moins une longueur d'onde de référence associée à la page clé (p-22) et une pluralité de longueurs d'onde fixées prédéterminées associées chacune à une page utilisateur,
dans lequel, lors de l'enregistrement de la page clé (p-22), le contrôleur de longueur d'onde (30') fait varier en continu la longueur d'onde de faisceau dans une plage de longueurs d'onde prédéterminée contenant la longueur d'onde de référence, la variation continue de la longueur d'onde de faisceau étant effectuée durant l'irradiation de la région d'enregistrement d'unité (T) avec le faisceau d'enregistrement (S) et le faisceau de référence (R), tandis que lors de l'enregistrement d'une page utilisateur, durant l'irradiation de la région d'enregistrement d'unité (T) avec le faisceau d'enregistrement (S) et le faisceau de référence (R), le contrôleur de longueur d'onde (30') maintient la longueur d'onde de faisceau fixée à l'une des longueurs d'onde fixées prédéterminées associée à une page utilisateur.

5. Enregistreur d'hologramme pour enregistrement holographique multiple, l'enregistreur comprenant :
un système optique (1-12) pour appliquer un faisceau d'enregistrement (S) et un faisceau de référence (R) à une région d'enregistrement d'unité (T) d'un support d'enregistrement d'hologramme (B), le faisceau d'enregistrement (S) étant modulé en fonction d'informations à enregistrer, le faisceau de référence (R) ayant la même longueur d'onde que la longueur d'onde du faisceau d'enregistrement (S) et étant modulé en taches ; et
un contrôleur de taille de taches (30") pour régler la taille des taches du faisceau de référence (R) à des tailles fixées, le réglage de la taille des taches à une taille sélectionnée parmi les tailles fixées permettant l'enregistrement holographique pour une page ;
dans lequel la région d'enregistrement d'unité (T) est adaptée à enregistrer une pluralité de pages incluant une page clé (p-22) et une page utilisateur,
dans lequel les tailles fixées comportent au moins une taille de référence associée à la page clé (p-22) et une pluralité de tailles fixées prédéterminées associées chacune à une page utilisateur,
dans lequel, lors de l'enregistrement de la page clé (p-22), le contrôleur de taille de taches (30") fait varier en continu la taille des taches dans une plage de tailles prédéterminée contenant la taille de référence, la variation continue de la taille des taches étant effectuée durant l'irradiation de la région d'enregistrement d'unité (T) avec le faisceau d'enregistrement (S) et le faisceau de référence (R), tandis que lors de l'enregistrement d'une page utilisateur, durant l'irradiation de la région d'enregistrement d'unité (T) avec le faisceau d'enregistrement (S) et le faisceau de référence (R), le contrôleur de taille de taches (30") maintient la taille des taches fixée à l'une des tailles fixées prédéterminées associée à une page utilisateur.

6. Procédé d'enregistrement d'hologramme pour enregistrement holographique multiple, le procédé comprenant les étapes consistant à :
appliquer un faisceau d'enregistrement (S) et un faisceau de référence (R) à une région d'enregistrement d'unité (T) d'un support d'enregistrement d'hologramme (B), le faisceau d'enregistrement (S) étant modulé en fonction d'informations à enregistrer, le faisceau de référence (R) ayant la même longueur d'onde que le faisceau d'enregistrement (S) ;
régler à des angles fixés (θ20-θ24) l'angle d'incidence d'un faisceau parmi le faisceau d'enregistrement (S) et le faisceau de référence (R) ; et
enregistrer un hologramme (H20-H24) pour une page à chaque fois que l'angle d'incidence est réglé à l'un des angles fixés (θ20-θ24) ;
dans lequel la région d'enregistrement d'unité (T) est adaptée à enregistrer une pluralité de pages incluant une page clé (p-22) et une page utilisateur,
dans lequel les angles fixés (θ20-θ24) comportent au moins un angle de référence (θ22) associé à la page clé (p-22) et une pluralité d'angles fixés prédéterminés (θ20, θ21, θ23, θ24) associés chacun à une page utilisateur,
dans lequel, lors de l'enregistrement de la page clé (p-22), on fait varier en continu l'angle d'incidence dans une plage angulaire prédéterminée (Δθ) contenant l'angle de référence (θ22), la variation continue de l'angle d'incidence étant effectuée durant l'irradiation de la région d'enregistrement d'unité (T) avec le faisceau d'enregistrement (S) et le faisceau de référence (R), tandis que lors de l'enregistrement d'une page utilisateur, durant l'irradiation de la région d'enregistrement d'unité (T) avec le faisceau d'enregistrement (S) et le faisceau de référence (R), l'angle d'incidence est maintenu fixé à l'un des angles fixés prédéterminés (θ20, θ21, θ23, θ24) associé à une page utilisateur.

7. Procédé d'enregistrement d'hologramme pour enregistrement holographique multiple, le procédé comprenant les étapes consistant à :
appliquer un faisceau d'enregistrement (S) et un faisceau de référence (R) à une région d'enregistrement d'unité (T) d'un support d'enregistrement d'hologramme (B), le faisceau d'enregistrement (S) étant modulé en fonction d'informations à enregistrer, le faisceau de référence (R) ayant la même longueur d'onde de faisceau que la longueur d'onde de faisceau du faisceau d'enregistrement (S) ;
régler la longueur d'onde de faisceau du faisceau d'enregistrement (S) et du faisceau de référence (R) à des longueurs d'onde fixées ; et
enregistrer un hologramme (H20-H24) pour une page à chaque fois que la longueur d'onde de faisceau est réglée à l'une des longueurs d'onde fixées ;
dans lequel la région d'enregistrement d'unité (T) est adaptée à enregistrer une pluralité de pages incluant une page clé (p-22) et une page utilisateur,
dans lequel les longueurs d'onde fixées comportent au moins une longueur d'onde de référence associée à la page clé (p-22) et une pluralité de longueurs d'onde fixées prédéterminées associées chacune à une page utilisateur,
dans lequel, lors de l'enregistrement de la page clé (p-22), on fait varier en continu la longueur d'onde de faisceau dans une plage de longueurs d'onde prédéterminée contenant la longueur d'onde de référence, la variation continue de la longueur d'onde du faisceau étant effectuée durant l'irradiation de la région d'enregistrement d'unité (T) avec le faisceau d'enregistrement (S) et le faisceau de référence (R), tandis que lors de l'enregistrement d'une page utilisateur, durant l'irradiation de la région d'enregistrement d'unité (T) avec le faisceau d'enregistrement (S) et le faisceau de référence (R), la longueur d'onde du faisceau est maintenue fixée à l'une des longueurs d'onde fixées prédéterminées associée à une page utilisateur.

8. Procédé d'enregistrement d'hologramme pour enregistrement holographique multiple, le procédé comprenant les étapes consistant à :
appliquer un faisceau d'enregistrement (S) et un faisceau de référence (R) à une région d'enregistrement d'unité (T) d'un support d'enregistrement d'hologramme (B), le faisceau d'enregistrement (S) étant modulé en fonction d'informations à enregistrer, le faisceau de référence (R) ayant la même longueur d'onde que la longueur d'onde du faisceau d'enregistrement (S) et étant modulé en taches ;
régler la taille des taches du faisceau de référence (R) à des tailles fixées ; et
enregistrer un hologramme (H20-H24) pour une page à chaque fois que la taille des taches est réglée à l'une des tailles fixées ;
dans lequel la région d'enregistrement d'unité (T) est adaptée à enregistrer une pluralité de pages incluant une page clé (p-22) et une page utilisateur,
dans lequel les tailles fixées comportent au moins une taille de référence associée à la page clé (p-22) et une pluralité de tailles fixées prédéterminées associées chacune à une page utilisateur,
dans lequel, lors de l'enregistrement de la page clé (p-22), on fait varier en continu la taille des taches dans une plage de tailles prédéterminée contenant la taille de référence, la variation continue de la taille des taches étant effectuée durant l'irradiation de la région d'enregistrement d'unité (T) avec le faisceau d'enregistrement (S) et le faisceau de référence (R), tandis que lors de l'enregistrement d'une page utilisateur, durant l'irradiation de la région d'enregistrement d'unité (T) avec le faisceau d'enregistrement (S) et le faisceau de référence (R), la taille des taches est maintenue fixée à l'une des tailles fixées prédéterminées associée à une page utilisateur.
